# EUROPEAN PATENT SPECIFICATION

(11) **EP 4 026 410 B1**
(45) Date of publication and mention of the grant of the patent: **04.03.2026**
(21) Application number: 20786104.8
(22) Date of filing: 08.09.2020
(51) Int. Cl.: H05K 7/20, B64C 1/36, H01Q 1/28, H01Q 1/42, B64C 7/00, H01Q 3/36, H01Q 21/06, H01Q 21/28

(54) **MOUNTING SYSTEM FOR MOUNTING AN ELEMENT TO AN AIRCRAFT SURFACE**
MONTAGESYSTEM ZUM MONTIEREN EINES ELEMENTES AN EINER FLUGZEUGOBERFLÄCHE
SYSTÈME DE MONTAGE POUR LE MONTAGE D'UN ÉLÉMENT SUR UNE SURFACE D'AÉRONEF

(30) Priority: 06.09.2019 US 201962896911 P
(43) Date of publication of application: 13.07.2022
(73) Proprietor: Amphenol Cable and Interconnect Technologies, Inc., Saint Augustine, FL 32092 (US)
(72) Inventor: PURPUS, Bradley J., New Berlin, WI 53151 (US); KRAMER, Michael I., Greendale, WI 53129 (US)
(74) Representative: Reddie & Grose LLP
(86) International application number: PCT/US2020/049699
(87) International publication number: WO 2021/046527

(56) References cited:
- US-A- 4 057 104
- US-A- 4 635 709
- US-A- 4 674 704
- US-A- 5 049 891
- US-B1- 6 205 803

## Description

### Technical Field of the Invention

The present invention relates generally to an electronics system for an aircraft and particularly to an electronics system having a cooling features for dissipating large amounts of heat.

### Background of the Invention

In avionics, various communications and antenna systems are used in an aircraft for the performance of the aircraft and other functions. Such aircraft mounted electronic systems often involve and use various electronic components and active antenna elements for communicating with ground-based or satellite-based communication systems. Active electronic systems generate heat that must be addressed and preferably removed from the electronic systems.

In the case of active antenna systems, a large amount of heat is generated and must be removed to prevent damage to the various electronic components and subsystems that make up the active antenna system. To that end, the active antenna systems are often mounted on the outside of the plane, such as to a fuselage surface, where they may potentially be exposed, in use, to an airflow in flight. The electronic systems, such as those used in electronically steered phased array antenna systems, must be exposed to a sufficient flow of air. However, with the significant amounts of heat generated by such systems, further cooling is necessary. Current solutions have various drawbacks.

Some such systems are not sufficient to remove the large amounts of heat that are generated by current active antenna technology. Other systems incorporate different metal materials, such as copper and aluminum, that create galvanic corrosion due to dissimilar metal contact. Still other systems do not provide sufficient isothermalization of the components, which is desired for sufficient performance of the antenna equipment.

Accordingly, there is a need to improve the electronic systems and particularly to improve the cooling features for electronic systems that generate significant amounts of heat. There is a further need to improve systems incorporating active antenna components and elements that are used in aircraft applications and are mounted on the outside surfaces of the aircraft. There is still a further need to provide such improved cooling features in an electronic system that may be easily mounted on a surface of an aircraft or other structure, wherein the surface layout may vary slightly from surface to surface.

US 6,205,803 B1 describes a thermal control method and apparatus that flows refrigerant of a vapor compression system through a plate of an avionics pod so as to provide a compact and efficient cooling technique for aircraft performing a variety of missions. The plate can serve as an evaporator in a heat pump loop or a heat exchanger in a pumped coolant loop. As a result, the same components can be used for convection cooling and compressor-assisted cooling. At lower temperatures, the pump is operational whereas under less favorable conditions the compressor is operable. A bypass can be provided to provide thermal control where ambient temperature is excessively low. A water boiler can also be utilized when, for short periods, the ambient temperature is higher than the desired temperature for the electronics package.

US 5,049,891 A relates to high-powered antenna installations employable in rotatable electrical systems for the transmission and reception of electromagnetic energy and, more particularly, relates to an integral radome-antenna structure which is mounted for rotation on the exterior of an aircraft. It proposes the use of a rotating equipment rack which is arranged interiorly of the aircraft fuselage, such as within the cabin space of the aircraft, and which is rigidly fastened to and concurrently rotatable with the rotating shaft supporting the radome-antenna installation for rotation, so as to constitute essentially a unitary assembly therewith. This enables that practically all of the surveillance system equipment be contained in the radome; in essence, the antenna array and associated electrical and signal receiving components, and the rotating equipment rack supporting surveillance system components mounted on the rotatable shaft may be permanently or hardwired together so as to impart a greater degree of efficiency and resultingly reduced power losses and signal distortion to the system.

US 4,674,704 A describes a direct air cooling system for electronics carried by aircraft. The cooling system provides a submerged air scoop which directs outside air to several electronic modules. The air flows through passages in the modules which are adjacent to circuit boards bearing discrete electronic components. A foil layer and aluminum fin stock help transfer heat from the electronic components to the directed air. Heated air is then exhausted through exhaust port.

US 4,635,709 A describes a dual mode heat exchanger for cooling airborne electronics through a cold plate. The heat exchanger either radiates heat to air through radiator fins or absorbs heat by evaporative cooling. A liquid coolant contained in grooves of the cold plate boils at a preselected temperature and thereby absorbs heat energy. Vapor released by the boiling liquid is exhausted through a hydrophobic filter membrane.

US 4,057,104 A describes a streamlined electronic-component-containing pod mounted on the exterior of a military aircraft in subjection to the airflow past the aircraft during flight. An evaporator in the pod is close coupled thermally to the electronic components for cooling. The outer skin of the pod acts as a condenser for return of liquid refrigerant to the evaporator during normal flight operations. During short-term high-speed dash operation the outer skin of the pod becomes too hot for condensing refrigerant vapor, which then becomes condensed by a heat sink. At this time the refrigerant at the outer skin remaining in the vapor phase acts as thermal insulation.

### Summary of the Invention

The invention relates to a mount system for mounting an electronics system for an aircraft as defined by claim 1.

Features of some embodiments, including embodiments in which an electronic system is received on the mount system, are recited in dependent claims.

### Brief Description of the Drawings

The accompanying drawings, which are incorporated in and constitute a part of this specification, illustrate embodiments of the invention and together with the detailed description given below, serve to explain various aspects of the invention.
Fig. 1 is a rear perspective view of an electronic system in accordance with an embodiment of the invention.
Fig. 2 is a front perspective view of an electronic system in accordance with the embodiment of the invention in Figure 1.
Fig. 2A is a front perspective view of an electronic system in accordance with an alternative embodiment of the invention.
Fig. 3 is a front cross-sectional view of an electronic system as in Figure 1 in accordance with the embodiment of the invention in Figure 1.
Fig. 4 is a perspective view of an electronic system with a cover element shown in phantom in accordance with the embodiment of the invention in Figure 1.
Fig. 5 is an exploded perspective view of an electronic system in accordance with the embodiment of the invention in Figure 1.
Fig. 6 is a perspective view of an electronic system with a cover element removed to show heat flow in accordance with an embodiment of the invention.
Fig. 7 is a top plan view of an electronic system showing a plate element with and alternating liquid slugs and vapor plugs along its length in accordance with the invention.
Fig. 8 is an exploded perspective view of an electronic system in accordance with an embodiment of the invention.
Fig. 9 is a rear perspective view of an electronic system in accordance with an alternative embodiment of the invention.
Fig. 10 is a front perspective view of an electronic system in accordance with the alternative embodiment of the invention of Figure 9.
Fig. 11 is a front cross-sectional view of an electronic system as in Figure 1 in accordance with the alternative embodiment of the invention of Figure 9.
Fig. 12 is an exploded perspective view of an electronic system in accordance with the alternative embodiment of the invention of Figure 9.
Fig. 13 is a front cross-sectional view of an electronic system as in accordance with another alternative embodiment of the invention.
Fig. 14 is an exploded perspective view of an electronic system in accordance with the alternative embodiment of the invention of Figure 13.

It should be understood that the appended drawings are not necessarily to scale, presenting a somewhat simplified representation of various features illustrative of the basic principles of the invention. The specific design features of the sequence of operations as disclosed herein, including, for example, specific dimensions, orientations, locations, and shapes of various illustrated components, will be determined in part by the particular intended application and use environment. Certain features of the illustrated embodiments have been enlarged or distorted relative to others to facilitate visualization and clear understanding. In particular, thin features may be thickened, for example, for clarity or illustration.

### Detailed Description of Embodiments of the Invention

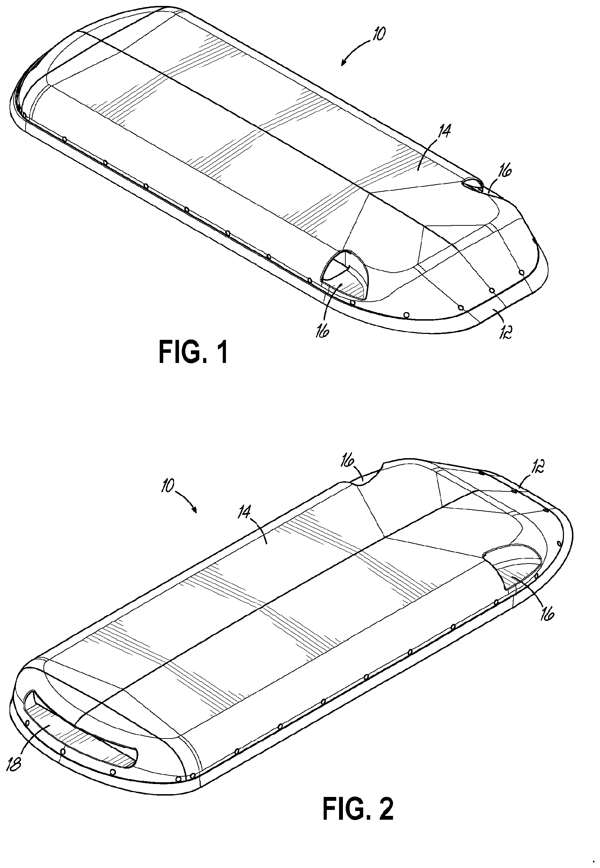

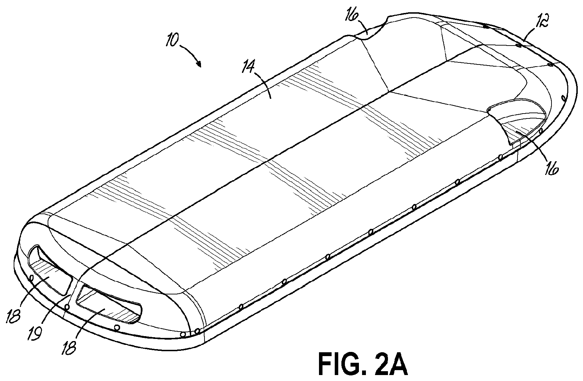

Figures 1 and 2 illustrate a front perspective view and a rear perspective view, respectively, for an electronic system in accordance with the present invention. Specifically, system 10 will contain one or more operating electronic systems that generate heat that must then be removed or dissipated for proper operation of the system. System 10 incorporates a mounting structure 12 which is used to mount the one or more electronic systems to a surface. A cover structure 14 then covers such electronic systems and other components of the system 10 and interfaces with the mounting structure 12 as described herein. The cover structure 14 includes one or more apertures or openings 16 to allow the flow of air underneath the cover structure. Referring to Figure 2, a forward aperture 18 provides another inlet or opening for introducing the flow of air through system 10 and underneath the cover structure 14. Figure 2A illustrates an alternative version of the invention wherein the cover 14 incorporates a plurality of forward apertures 18 separated by a wall 19 of the cover for dividing the inflow of air into the system for cooling as described herein.

System 10 is mounted to an operational surface, such is an aircraft surface and the invention is particularly useful for mounting electronic systems used with an aircraft, such as active antenna systems. In one embodiment of the invention, the system 10 incorporates active electronic systems, such as electronically steered phased array antenna systems, but the invention is not limited to such electronics systems. In one feature of the invention, the electronic system 10 of the invention is useful for removing significant amounts of heat that is associated with the operation of the active electronics systems.

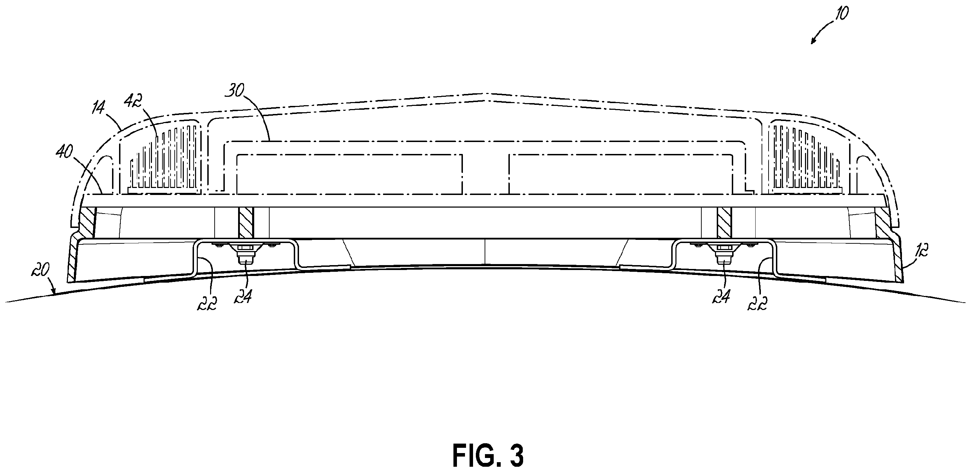

Referring to Figure 3, a front view of system 10 is shown with the system mounted on a surface 20, such as a wing or fuselage surface of an aircraft. As may be appreciated, such a surface 20 may be curved or may present an inconsistent surface for mounting. To that end, structures 22 interfacing with the surface 20 may be positioned along the surface 20. The various mounting elements 22 are fixed to the surface 20 and additional mounting elements 24 then engage with the mounting elements 22. For the purposes of the invention, other mounting elements might also be used such as those described in US Patent Application Serial No. 16/516,839 filed July 19, 2019 and entitled Mounting System for Mounting an Element to an Aircraft Surface and US Patent Application Serial No. 15/656,447 filed July 21, 2017 and entitled Mounting System for Mounting an Element to a Surface may be utilized. System 10 is thus arranged, such as on an aircraft surface to be presented with a flow of air that will be directed into system 10 through the aperture 18 of the cover structure 14, to be directed around electronics systems and around other elements of system 10 as described herein. The air circulates under the cover structure and is directed out of apertures 16. As may be appreciated, in a moving aircraft, the flow is provided as appropriate for various apertures 16, 18.

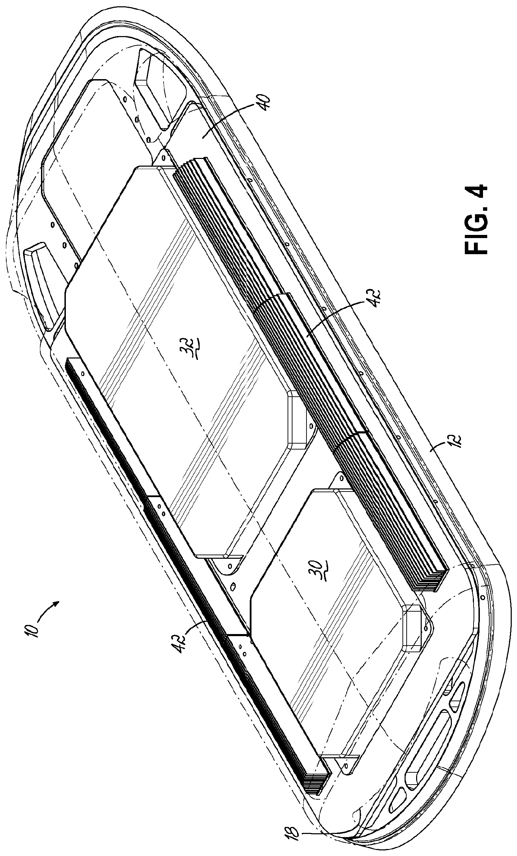

Figure 4 is a perspective view showing a transparent cover structure 14 for exposing the system elements and components. System 10 includes one or more electronic systems 30, 32 which are mounted to the mounting structure 12 and contained under the cover structure 14. Various electronic systems used in aviation may include one or more antennas or antenna elements. More specifically, aircraft may use phased array antenna systems that may be electronically steered. Such steered phased array antenna systems generate a significant amount of heat that must be dissipated for the proper operation of the electronic systems.

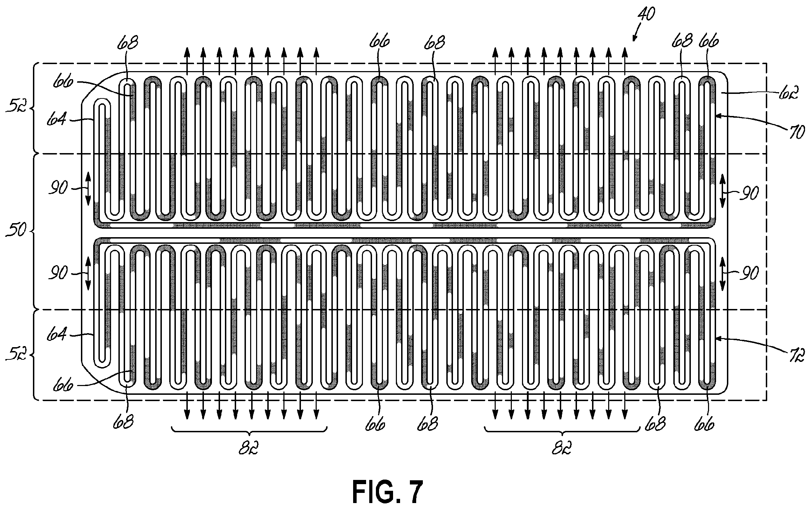

In accordance with one feature of the invention, system 10 incorporates a thermally conductive and generally planar plate element 40 that is thermally coupled with the electronic systems 30, 32. The plate element has opposing face surfaces 41, 43 that define a central region 50 and edge regions 52 extending along the length of the oscillating heat pipe 40 on either side of the central region 50. A serpentine passage 64 is formed in the plate element between the face surfaces 41, 43. In one embodiment, the serpentine passage is a tubular passage that contains a liquid that is broken up by plugs of vapor to form alternating liquid slugs 66 and vapor plugs 68 along the length of the serpentine passage. (See Fig. 7) The plate element is made of a thermally conductive material, such as aluminum or copper, for example, and gathers heat from the electronic systems 30, 32. The plate element passes the heat to the serpentine passage 64 and thereby to the alternating liquid slugs 66 and vapor plugs 68. The heating of the alternating liquid slugs and vapor plugs 66, 68 provides an expansion of the vapor plugs and transfer of heat along the serpentine passage 64 and the interaction moves the gathered heat proximate the central region to the side edge regions in an oscillating manor. To that end, the plate element 40 provides a structure in the form of an oscillating heat pipe 40 that thermally interfaces with the active electronics systems 30, 32 and any other electronic components of system 10. As noted, the oscillating heat pipe structure 40, 64 is configured for gathering heat proximate one region and then moving the heat to other regions for being dissipated.

To that end, the system 10 also incorporates one or more heat sinks 42 that are also thermally coupled with the plate element and positioned proximate or at the edge regions 52 for dissipating heat of the electronics system moved to the side edge regions. The heat moved from the central region 50 to the side regions 52 is then conductively passed to the heat sinks 42 to be removed from the system 10 as described herein.

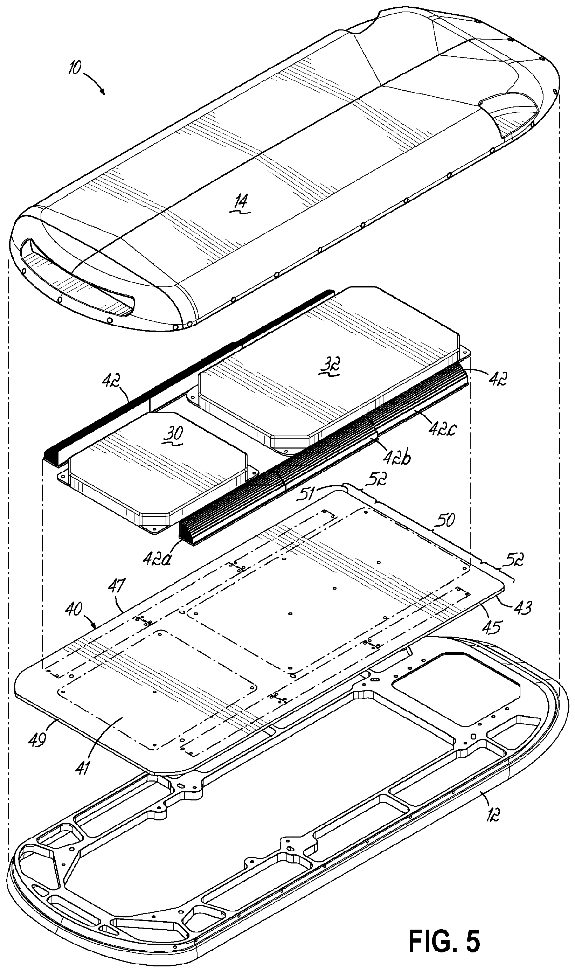

More specifically, referring to Figure 5, an exploded view of system 10 is shown wherein the mounting structure 12 forms a base and the plate element 40 forming an oscillating heat pipe is mounted to the mounting structure. Mounting structure 12 may be formed of a suitable material, such as aluminum or some other material for providing a structurally robust base to the electronics system 10. The plate element 40 is secured to the mounting structure 12, such as by fasteners (not shown). The plate element is illustrated as a generally planar structure having opposing face surfaces 41, 43 and opposing edges 45, 47 as well as a front edge 49 and a rear edge 51. As noted, the plate element includes the central region 50 for containing electronic systems 30, 32 and includes side edge regions 52 extending along the length of the oscillating heat pipe 40 on either side of the central region 50 for interfacing with the heat sinks 42.

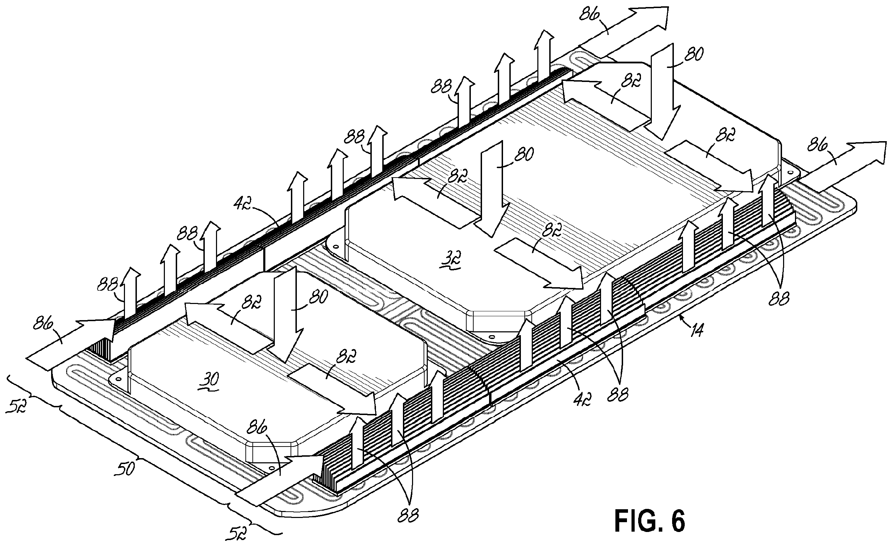

As illustrated in Figure 6, in one embodiment invention, the active electronic systems 30, 32 are mounted on a face surface 41 of the plate element proximate to the central region 50. As illustrated in the figures, two active electronic systems 30 and 32 are illustrated. However, a greater or lesser number of active electronic systems may be implemented. The electronic systems 30, 32 are appropriately thermally coupled to the plate element 40 proximate to the central region 50 and thereby deliver heat to the plate element in that region. On either side of the central region, the side edge regions 52 are appropriately dimensioned for receiving the heat sinks 42 which are also thermally coupled with the plate element in a position along the side edge regions 52 thereof for dissipating heat of the electronics systems 30, 32. As discussed further herein, the plate element and passage 64 with liquid/vapor slugs/plugs 66, 68 is configured to act as an oscillating heat pipe and operable for gathering heat proximate the central region 50 from each of the one or more electronic systems 30, 32 and then directing or moving the heat to the side edge regions 52. The moved heat is then transferred to the heat sinks 42 to be convectively dissipated.

Heat sinks 42 may be a unitary structures or, as illustrated in the figures, may incorporate various sections, such as heat sink sections 42a, 42b, 42c as illustrated in Figure 5 that make up a longer composite heat sink 42. The heat sinks extend generally along the length of the plate element on either side of the plate element and electronic systems 30, 32. To that end, each of these sections 42a-42c may be thermally coupled with appropriate subregions of the side edge regions 52 as shown in Figure 5. Also, each of the separate heat sink sections may be separately secured to the oscillating heat pipe by appropriate fasteners or methods. Referring to Figure 6, the heat sinks may be any form for dissipating heat delivered by the plate element 40 and passage 64. In the illustrated embodiment, the heat sinks 42 would convectively dissipate the heat and include a series of fins 60 which may be appropriately arranged and dimensioned for the efficient convective transfer of heat to the air.

In accordance with another feature of the invention, the apertures 16 and 18 within the cover structure are positioned to direct a flow of air over the respective heat sinks 42. That is, when system 10 is mounted to an aircraft, the system is mounted so that the cover structure aperture 18 is in line with the direction of the travel of the aircraft for providing a directional flow of air through the aperture 18 and over the heat sinks 42 and then out the apertures 16 to remove the heat from underneath the cover structure 14 and away from system 10.

Referring to Figure 7, a top view of a plate element 40 and serpentine passage 64 is illustrated in accordance with one aspect of the present invention for operating at an oscillating heat pipe. The plate element 40 includes a body structure 62 that is formed of a suitable conductive material such as aluminum, although other conductive materials such as copper might be used. The body 62 is configured to include or form one or more generally tubular passages 64 that contain a working fluid, such as water or alcohol or any appropriate fluid. The fluid is present in the passage in both liquid and vapor form. As shown the passages 64 are laid out in a serpentine arrangement in the plate element body 62. More specifically, the passages 64 may be formed as an interconnected configuration as illustrated in Figure 7 forming a closed system which includes the alternating slugs or plugs of a liquid 66 and gas or vapor 68 as shown. The passages 64 seal the alternating liquid slugs 66 and gas or vapor plugs 68 and so the heat delivered to the plate element and passages 64 affect the size and arrangement of the liquid slugs and vapor plugs 66, 68 in an oscillating fashion and thereby rapidly move heat from one area of the plate element to another area. In one embodiment of the invention, one such configuration may include two such passages 64 wherein one passage may be positioned on one side of the plate element 40 and another similar configuration might be positioned on the other side of the plate element as shown in Figure 7. The plate element and its oscillating heat pipe feature is configured for gathering the heat from the electronics systems 30, 32 proximate to the central region 50 and then directing or moving that heat out to the side edge regions 52 where it can be dissipated. More specifically, the plate element, through a pulsating or oscillating flow of the liquid slugs 66 and vapor plugs 68, transfers heat efficiently from the central region out to the side edge regions 52. At those side edge regions, the engagement with the various heat sinks will draw the heat from the side edge regions of the plate element to the heat sinks so that it may then be convectively dissipated through a flow of air over the heat sinks created by system 10 and its apertures 16, 18. While the oscillating heat pipe plate element 40 illustrated in Figure 7 shows two different passage configurations 70 and 72 which operate together, there may be a single configuration that seals the liquid slugs and vapor plugs 66, 68 and then provides the same directional heat flow from the central region 50 out to the various side edge regions 52. Similarly, there may be a greater number of configurations 70, 72 which operate together in sections of the plate element to form the oscillating heat pipe functionality to provide a similar flow of heat energy from the central region out to the side edge regions for dissipation through the heat sinks. As such, the invention is not limited to the specific arrangement and configuration of the tubular passages 64 as shown in the figures.

Referring the Figures 6 and 7, heat energy movement and airflow is shown to illustrate the heat movement and removal through the electronic system 10 of the invention. Specifically, as illustrated by arrows 80, heat generated by the electronic systems 30, 32, such as the active electronic systems associated with phased antenna arrays will move generally downwardly from the electronics systems 30, 32 to the plate element 40 as shown. Then, the plate element 40 acting as an oscillating heat pipe configuration will operate to move the heat as shown by arrows 82 from the central region out to the side edge regions 52. As illustrated in Figure 6 by arrows 82, the heat will be delivered to the heat sinks 42. Then, a flow of air is illustrated by arrows 86 is directed under cover 14 over the heat sinks 42 such that the heat is released up from the fins 60 of the heat sink as illustrated by the arrows 88.

As may be appreciated, heat will dissipate in various different directions over surfaces associated with the electronics systems 30, 32 and the face surfaces 41, 43 of the plate element 40 as well as over the length and height of the heat sinks 42 and associated fins 60. As such, the various heat flow arrows 82, 84, 86, and 88 are not limiting with respect to the direction in which heat may actually move. Rather, the arrows provide general reference directions with respect to the flow of heat from the electronics systems to the plate element 40, and then out from the central region to the side edge regions to be dissipated through the various heat sinks 42. Referring to Figure 7, with the plate element and the configurations 70, 72 of the tubular passages 64, the heat will generally oscillate or pulsate back-and-forth with the movement of the liquid slugs and vapor plugs 66, 68 as shown by arrow 90. The general movement of the heat will be in the direction of arrows 82 away from the central region 50 and toward the side edge regions 52 for dissipation.

In that way, in accordance with one aspect the present invention, significant amounts of heat generated by the electronics systems 30, 32 may be moved, and then removed from electronic system 10 for providing proper heat dissipation, isothermalization, and operation of the electronic system.

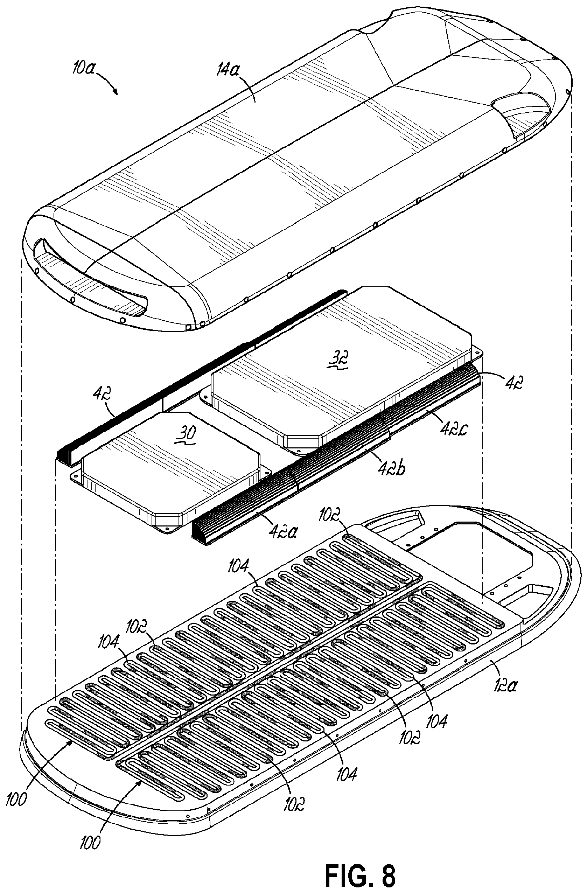

Figure 8 illustrates an alternative embodiment of the present invention 10a wherein the plate element and passages are fabricated and incorporated as part of the actual mounting structure 12a. Referring to Figure 8, a plate element or plate section that is formed as part of the mounting structure includes at least one face surface for coupling with electronic systems 30, 32. The various serpentine passages 100 having alternating liquid slugs 102 and vapor plugs 104 are formed within the body of the mounting structure 12a and within the plate body/section of the mounting structure. The passages 100 and alternating liquid slugs and vapor plugs 102, 104 create an oscillating heat pipe effect within the mounting structure to remove heat as disclosed herein. As illustrated in Figure 8, heat sink elements 42a, similar to heat sinks 42 are incorporated at the side edges of the mounting structure 12a. Electronic systems 30, 32 are coupled with the mounting structure and plate element for being mounted to a surface, such as an aircraft surface. The electronic systems 30, 32 are thermally coupled with the mounting structure, and particularly, the central region or center area of the mounting structure for thermally coupling to the passages 100 and alternating liquid slugs and vapor plugs 102, 104. In that way, as discussed herein with respect to another embodiment the present invention, the heat is captured by the mounting structure and due to the oscillating features of the mounting structure, the heat is gathered proximate to the center area of the mounting structure and moved to the side edges to be dissipated by heat sinks 42a. The mounting structure 12a provides both mounting of the electronics systems 30, 32 as well as dissipation of heat thereby eliminating the need for a separate plate element. As noted, the mounting structure provides flexibility with respect to mounting on an uneven surface such as an aircraft surface and provides the dissipation of a significant amount of heat that is generated by active electronics systems, such as active phased array antenna systems.

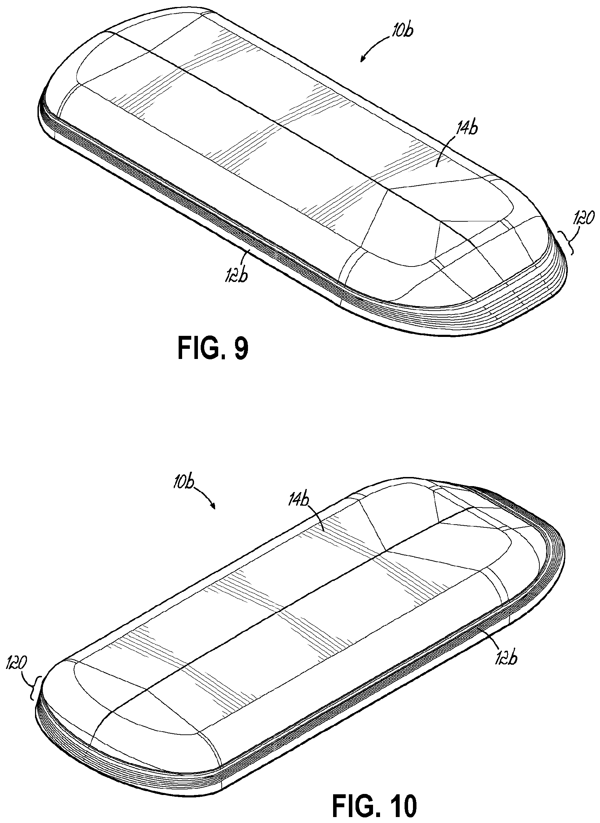

Figures 9 and 10 illustrate a front perspective view and a rear perspective view, respectively, for an alternative embodiment of the electronic system in accordance with the present invention. For common components, like reference numerals are utilized with respect to Figures 1-8. Specifically, system 10b will contain one or more operating electronic systems that generate heat that must then be removed or dissipated for proper operation of the system. However, system 10b incorporates a mounting structure 12b that incorporates heat sink components directly into the mounting structure and is used to mount the one or more electronic systems to a surface. A cover structure 14b then covers such electronic systems and other components of the system 10b and interfaces with the mounting structure 12b as described herein. Specifically, the mounting structure 12b has integrally formed fins 120 that are fabricated into the mounting structure. The fins are positioned to extend around a periphery of the mounting structure. In one embodiment as shown in the figures, the integral fins extend continuously around the periphery of the system. However, in other embodiments, the fins 120 might extend in more discrete sections, such as sections that extend along the sides of the system, similar to the heat sinks 42. The integral fins convectively exchange air that flows over the system 10b as discussed herein. To that end, the integral fins form a heat sink structure that is integral with the mounting structure 12b. The cover structure 14b covers the various electronics 30, 32 and the oscillating heat pipe 40 and because of the direct exposure of the fins 120 the cover does not require apertures or openings 16, 18 as the flow of air passes over the external fins 120.

System 10b is mounted to an operational surface, such is an aircraft surface and the invention is particularly useful for mounting electronic systems used with an aircraft, such as active antenna systems. In one embodiment of the invention, the system 10b incorporates active electronic systems, such as electronically steered phased array antenna systems, but the system 10b is not limited to such electronics systems. In one feature of the invention, the electronic system 10a of the invention is also useful for removing significant amounts of heat that is associated with the operation of the active electronics systems.

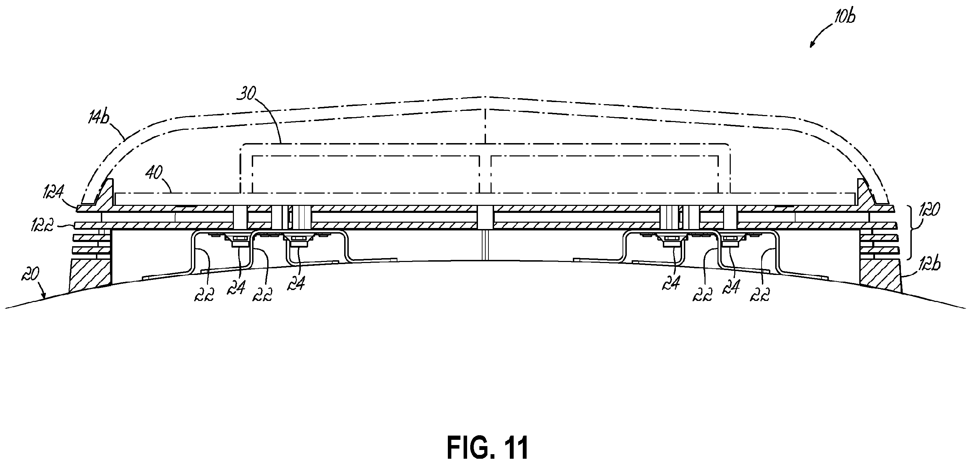

Referring to Figure 11, a front view of system 10b is shown with the system mounted on a surface 20, such as a wing or fuselage surface of an aircraft. As may be appreciated, such a surface 20 may be curved or may present an inconsistent surface for mounting. To that end, structures 22 interfacing with the surface 20 may be positioned along the surface 20. The various mounting elements 22 are fixed to the surface 20 and additional mounting elements 24 then engage with the mounting elements 22 as described herein for the embodiment illustrated in Figure 3. Similarly, for the purposes of the invention, other mounting elements might also be used such as those described in US Patent Application Serial No. 16/516,839 filed July 19, 2019 and entitled Mounting System for Mounting an Element to an Aircraft Surface and US Patent Application Serial No. 15/656,447 filed July 21, 2017 and entitled Mounting System for Mounting an Element to a Surface may be utilized. System 10 is thus arranged, such as on an aircraft surface to be presented with a flow of air that will engage the integral fins 120 of the mounting structure for removing heat from the electronics 30, 32 and oscillating heat pipe 40.

To that end, the oscillating heat pipe 40 is fabricated as described herein and includes one or more serpentine tubular passages that contain a liquid that is broken up by plugs of vapor to form alternating liquid slugs 66 and vapor plugs 68 along the length of the serpentine passages. (See Fig. 7) The plate element is made of a thermally conductive material, such as aluminum or copper, for example, and gathers heat from the electronic systems 30, 32. The oscillating heat pipe directs heat to the serpentine passages and thereby to the alternating liquid slugs 66 and vapor plugs 68. The heating of the alternating liquid slugs and vapor plugs 66, 68 provides an expansion of the vapor plugs and transfer of heat along the serpentine passage 64. The interaction moves the gathered heat proximate the central region to the side edge regions in an oscillating manor. The oscillating heat pipe thermally interfaces with the active electronics systems 30, 32 and any other electronic components of system 10b. As noted, the oscillating heat pipe structure 40, 64 is configured for gathering heat proximate one region and then moving the heat to other regions for being dissipated. The oscillating heat pipe is thermally coupled to the mounting structure and thus is thermally coupled to the integral fins 120. Heat from the oscillating heat pipe is conductively delivered to the fins 120 to be convectively removed by an airflow, such as the air flow associated with a moving aircraft. In one embodiment, the integral fins 120 are formed and configured to surround the system and the mounting structure 12a for efficient heat transfer all the way around the oscillating heat pipe and system 10a.

For efficient conduction of heat to the fins, as illustrated in Figure 11, several of the integral fins are integrally formed with plate portions 122, 124 of the mounting structure as shown. For example, the oscillating heat pipe 40, and particularly one of the face surfaces 41, 43 of the plate element forming the oscillating heat pipe 40 is thermally coupled with the plate portion 124 for efficient thermal transfer.

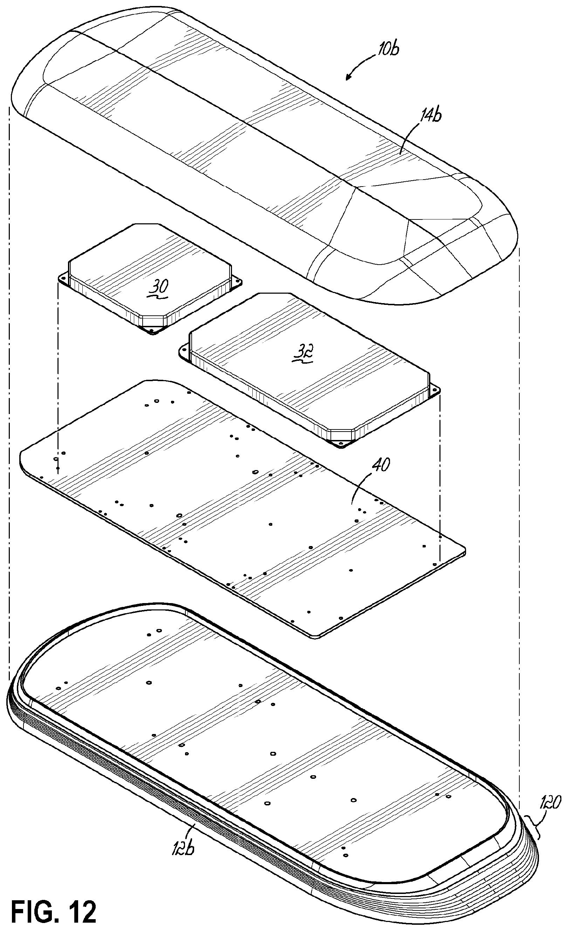

More specifically, referring to Figure 12, an exploded view of system 10a is shown wherein the mounting structure 12b forms a base and the plate element 40 forming an oscillating heat pipe is mounted to the mounting structure. Mounting structure 12b and fins 120 may be formed of a suitable material, such as aluminum or some other material for providing a structurally robust base to the electronics system 10 and a thermally conductive material for the fins 120 for the convective removal of heat. The plate element 40 is secured to the mounting structure 12, such as by fasteners (not shown). The plate element is illustrated as a generally planar structure having opposing face surfaces 41, 43 and opposing edges 45, 47 as well as a front edge 49 and a rear edge 51. As noted, the plate element includes the central region 50 for containing electronic systems 30, 32.

The oscillating heat pipe 40 as shown in Figures 9-12 operates as described herein in Figures 6-7. Therein, the active electronic systems 30, 32 are mounted on a face surface 41 of the plate. As illustrated in the figures, two active electronic systems 30 and 32 are illustrated. However, a greater or lesser number of active electronic systems may be implemented. The electronic systems 30, 32 are appropriately thermally coupled to the plate element 40 proximate to the central region 50 and thereby deliver heat to the plate element in that region. On either side of the central region, the side edge regions 52 are appropriately configured to deliver heat to the integral fins 120. As discussed further herein, the plate element and passage 64 with liquid/vapor slugs/plugs 66, 68 is configured to act as an oscillating heat pipe and operable for gathering heat proximate the central region 50 from each of the one or more electronic systems 30, 32 and then directing or moving the heat to the side edge regions 52. The moved heat is then transferred to the integral fins to be convectively dissipated.

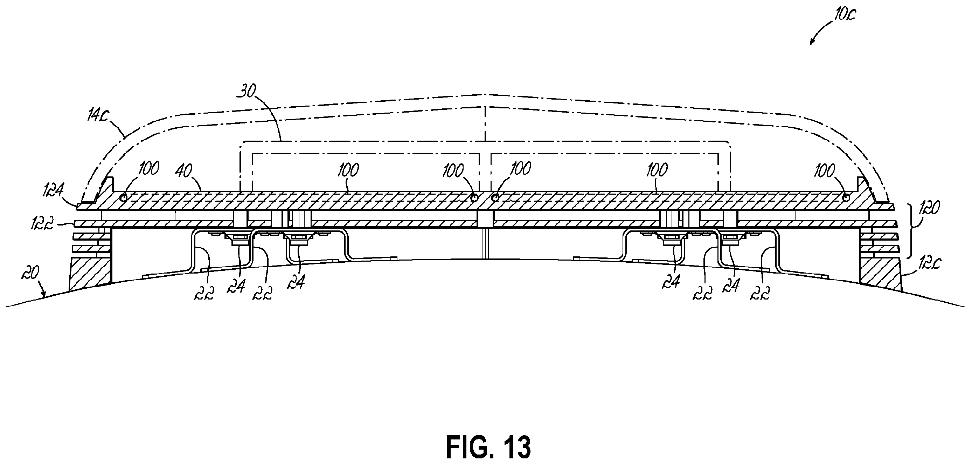

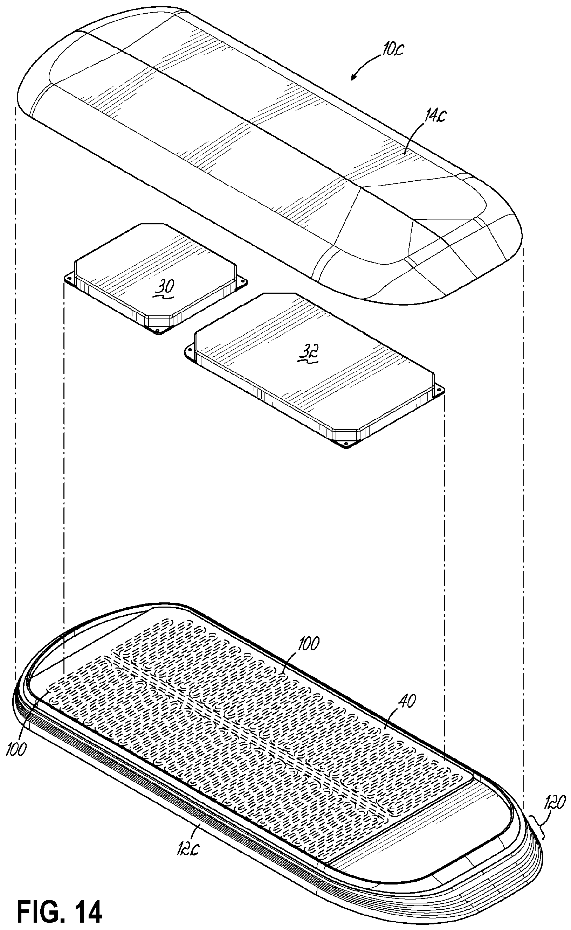

Figures 13 and 14 illustrate another alternative embodiment of the present invention wherein the plate element and passages are fabricated and incorporated as part of the actual mounting structure 12c. Referring to Figure 13, the various serpentine passages 100 having alternating liquid slugs 102 and vapor plugs 104 are formed within the body of the mounting structure 12c. The passages 100 and alternating liquid slugs and vapor plugs 102, 104 create an oscillating heat pipe effect within the mounting structure to remove heat as disclosed herein. As illustrated in Figure 13, integral fins 120 are incorporated at the side edges of the mounting structure 12c. Electronic systems 30, 32 are coupled with the mounting structure for being mounted to a surface, such as an aircraft surface. The electronic systems 30, 32 are thermally coupled with the mounting structure 12c, and particularly, the central region or center area of the mounting structure for thermally coupling to the passages 100 and alternating liquid slugs and vapor plugs 102, 104. In that way, as discussed herein with respect to other embodiments the present invention, the heat is captured by the mounting structure and due to the oscillating features of the mounting structure, the heat is gathered proximate to the center area of the mounting structure and moved to the side edges to be dissipated by integral fins 120. The mounting structure 12c provides both mounting of the electronics systems 30, 32 as well as dissipation of heat thereby eliminating the need for a separate plate element 40. As noted, the mounting structure provides flexibility with respect to mounting on an uneven surface such as an aircraft surface and provides the dissipation of a significant amount of heat that is generated by active electronics systems, such as active phased array antenna systems.

While the present invention has been illustrated by a description of various embodiments and while these embodiments have been described in some detail, it is not the intention of the inventors to restrict or in any way limit the scope of the appended claims to such detail.

## Claims

1. A mount system for mounting an electronics system for an aircraft, the mount system comprising:
a mounting structure (12) for mounting to a surface of an aircraft;
a generally planar plate element (40), the plate element having opposing face surfaces (41, 43) and including a central region (50) and side edge regions (52) extending along a length of the plate element, a plate element face surface configured for receiving at least one electronic system proximate the central region of the plate element;
at least one serpentine passage (64, 100) formed in the plate element between the face surfaces, the at least one serpentine passage containing alternating liquid slugs (66, 102) and vapor plugs (68, 104) along its length, the plate element being configured for gathering heat proximate the central region and moving the heat to the side edge regions through interaction with the liquid slugs and vapor plugs of the at least one serpentine passage;
a heat dissipating structure thermally coupled with the plate element and positioned along a side edge region thereof for convectively dissipating heat from an electronic system that is moved to the side edge regions;
a cover structure for covering the plate element and at least one electronic system.

2. The mount system of claim 1 wherein the heat dissipating structure includes at least one heat sink (42) thermally coupled with the plate element and positioned along a side edge region thereof.

3. The mount system of claim 2 further comprising a plurality of heat sinks, a heat sink positioned along each of the side edge regions of the plate element.

4. The mount system of claim 1 wherein the cover structure includes at least one aperture in an end thereof for directing air over the heat dissipating structure.

5. The mount system of claim 4 comprising at least one rear aperture in an end of the cover structure opposite the at least one aperture for passage of air through the cover structure and over the heat dissipating structure.

6. The mount system of claim 1 wherein the plate element is thermally coupled with the mounting structure, the heat dissipating structure including a plurality of fins (60, 120) integrally formed with the mounting structure for convectively dissipating heat.

7. The mount system of claim 6 wherein the integrally formed fins (60, 120) extend around a periphery of the mounting structure.

8. The mount system of claim 1 wherein the plate element is one of mounted to the mounting structure or fabricated in the mounting structure.

9. The mount system of claim 1 comprising a plurality of serpentine passages (64) formed in the plate element.

10. The mount system of claim 9 wherein at least one of the plurality of serpentine passages is positioned proximate each of the side edge regions of the plate element.

11. The mount system of claim 1 further comprising at least one electronic system (30, 32) mounted on a face surface of the plate element proximate the central region.

12. The mount system of claim 11 wherein the electronic system includes an active antenna system.

13. The mount system of claim 8 further comprising a plurality of heat sinks, a heat sink positioned along each of the side edge regions of the mounting structure plate element.

14. The mount system of claim 11 wherein the heat dissipating structure includes a plurality of fins integrally formed with the mounting structure for convectively dissipating heat of the electronic system.

15. The mount system of claim 14 wherein the integrally formed fins extend around a periphery of the mounting structure and at least one serpentine passage is positioned proximate fins at the side edge regions of the plate element.

## Patentansprüche

1. Montagesystem zum Montieren eines Elektroniksystems für ein Luftfahrzeug, wobei das Montagesystem Folgendes umfasst:
eine Montagestruktur (12) zum Montieren an einer Oberfläche eines Luftfahrzeugs;
ein im Wesentlichen planares Plattenelement (40), wobei das Plattenelement gegenüberliegende Stirnflächen (41, 43) aufweist und einen zentralen Bereich (50) und seitliche Randbereiche (52) einschließt, die sich entlang einer Länge des Plattenelements erstrecken, wobei eine Stirnfläche des Plattenelements, die zum Aufnehmen mindestens eines elektronischen Systems eingerichtet ist, dem zentralen Bereich des Plattenelements nahe kommt;
mindestens einen Serpentinendurchgang (64, 100), der in dem Plattenelement zwischen den Stirnflächen ausgebildet ist, wobei der mindestens eine Serpentinendurchgang entlang seiner Länge abwechselnde Flüssigkeitsschnecken (66, 102) und Dampfstopfen (68, 104) beinhaltet, wobei das Plattenelement so eingerichtet ist, dass es Wärme nahe dem zentralen Bereich sammelt und die Wärme durch Wechselwirkung mit den Flüssigkeitsschnecken und Dampfstopfen in die seitlichen Randbereiche der mindestens einen Serpentinendurchgang bewegt;
eine mit dem Plattenelement thermisch gekoppelte Wärmeableitstruktur und entlang eines davon befindlichen seitlichen Randbereichs positioniert ist, um Wärme aus dem mindestens einem elektronischen System, das zu den seitlichen Randbereichen bewegt wird, konvektiv abzuleiten;
eine Abdeckstruktur zum Abdecken des Plattenelements und des mindestens einen elektronischen Systems.

2. Montagesystem nach Anspruch 1, wobei die Wärmeableitstruktur mindestens einen Kühlkörper (42) einschließt, der thermisch mit dem Plattenelement gekoppelt ist und entlang eines seitlichen Randbereichs davon positioniert ist.

3. Montagesystem nach Anspruch 2, weiter umfassend eine Vielzahl von Kühlkörpern, wobei ein Kühlkörper entlang jedes der seitlichen Randbereiche des Plattenelements positioniert ist.

4. Montagesystem nach Anspruch 1, wobei die Abdeckstruktur mindestens eine Öffnung an einem Ende davon zum Leiten von Luft über die Wärmeableitstruktur einschließt.

5. Montagesystem nach Anspruch 4, umfassend mindestens eine hintere Öffnung in einem der mindestens einen Öffnung gegenüberliegenden Ende der Abdeckstruktur zum Durchströmen von Luft durch die Abdeckstruktur und über die Wärmeableitstruktur.

6. Montagesystem nach Anspruch 1, wobei das Plattenelement thermisch mit der Montagestruktur gekoppelt ist, wobei die Wärmeableitstruktur eine Vielzahl von Rippen (60, 120) einschließt, die integral mit der Montagestruktur zum konvektiven Wärmeableiten ausgebildet ist.

7. Montagesystem nach Anspruch 6, wobei die integral ausgebildeten Rippen (60, 120) sich um einen Umfang der Montagestruktur erstrecken.

8. Montagesystem nach Anspruch 1, wobei das Plattenelement an der Montagestruktur montiert oder in der Montagestruktur hergestellt ist.

9. Montagesystem nach Anspruch 1, umfassend eine Vielzahl von Serpentinendurchgängen (64), die in dem Plattenelement ausgebildet sind.

10. Montagesystem nach Anspruch 9, wobei mindestens einer der Vielzahl von Serpentinendurchgängen nahe an jedem der seitlichen Randbereiche des Plattenelements positioniert ist.

11. Montagesystem nach Anspruch 1, weiter umfassend mindestens ein elektronisches System (30, 32), das an einer Stirnfläche des Plattenelements nahe dem zentralen Bereich montiert ist.

12. Montagesystem nach Anspruch 11, wobei das elektronische System ein aktives Antennensystem einschließt.

13. Montagesystem nach Anspruch 8, weiter umfassend eine Vielzahl von Kühlkörpern, wobei ein Kühlkörper entlang jedes der seitlichen Randbereiche der Montagestruktur des Plattenelements positioniert ist.

14. Montagesystem nach Anspruch 11, wobei die Wärmeableitstruktur eine Vielzahl von Rippen einschließt, die integral mit der Montagestruktur zum konvektiven Wärmeableiten des elektronischen Systems ausgebildet sind.

15. Montagesystem nach Anspruch 14, wobei sich die integral ausgebildeten Rippen um einen Umfang der Montagestruktur erstrecken und mindestens ein Serpentinendurchgang nahe den Rippen an den seitlichen Randbereichen des Plattenelements positioniert ist.

## Revendications

1. Système de montage pour monter un système électronique pour un aéronef, le système de montage comprenant :
une structure de montage (12) pour le montage sur une surface d'un aéronef ;
un élément de plaque (40) généralement plan, l'élément de plaque présentant des surfaces de face (41, 43) opposées et incluant une région centrale (50) et des régions de bord latéral (52) s'étendant le long d'une longueur de l'élément de plaque, une surface de face d'élément de plaque étant configurée pour recevoir au moins un système électronique à proximité de la région centrale de l'élément de plaque ;
au moins un passage en serpentin (64, 100) formé dans l'élément de plaque entre les surfaces de face, l'au moins un passage en serpentin contenant des bouchons de liquide (66, 102) et des bouchons de vapeur (68, 104) alternés sur sa longueur, l'élément de plaque étant configuré pour collecter de la chaleur à proximité de la région centrale et déplacer la chaleur vers les régions de bord latéral par interaction avec les bouchons de liquide et
les bouchons de vapeur de l'au moins un passage en serpentin ;
une structure dissipatrice de chaleur couplée thermiquement à l'élément de plaque et
positionnée le long d'une région de bord latéral de celle-ci pour dissiper par convection de la chaleur de l'au moins un système électronique déplacé vers les régions de bord latéral ;
une structure de recouvrement pour recouvrir l'élément de plaque et l'au moins un système électronique.

2. Système de montage selon la revendication 1, dans lequel la structure dissipatrice de chaleur inclut au moins un dissipateur thermique (42) couplé thermiquement à l'élément de plaque et positionné le long d'une région de bord latéral de celui-ci.

3. Système de montage selon la revendication 2 comprenant en outre une pluralité de dissipateurs thermiques, un dissipateur thermique étant positionné le long de chacune des régions de bord latéral de l'élément de plaque.

4. Système de montage selon la revendication 1, dans lequel la structure de couvercle inclut au moins une ouverture à une extrémité de celle-ci pour diriger de l'air sur la structure dissipatrice de chaleur.

5. Système de montage selon la revendication 4 comprenant au moins une ouverture arrière à une extrémité de la structure de couvercle opposée à l'au moins une ouverture de passage d'air à travers la structure de couvercle et sur la structure dissipatrice de chaleur.

6. Système de montage selon la revendication 1, dans lequel l'élément de plaque est couplé thermiquement à la structure de montage, la structure dissipatrice de chaleur incluant une pluralité d'ailettes (60, 120) formées d'un seul tenant avec la structure de montage pour dissiper de la chaleur par convection.

7. Système de montage selon la revendication 6, dans lequel
les ailettes (60, 120) formées d'un seul tenant s'étendent autour d'une périphérie de la structure de montage.

8. Système de montage selon la revendication 1, dans lequel l'élément de plaque est soit monté sur la structure de montage ou fabriqué dans la structure de montage.

9. Système de montage selon la revendication 1 comprenant une pluralité de passages en serpentin (64) formés dans l'élément de plaque.

10. Système de montage selon la revendication 9, dans lequel au moins l'un de la pluralité de passages en serpentin est positionné à proximité de chacune des régions de bord latéral de l'élément de plaque.

11. Système de montage selon la revendication 1 comprenant en outre au moins un système électronique (30, 32) monté sur une surface de face de l'élément de plaque à proximité de la région centrale.

12. Système de montage selon la revendication 11, dans lequel le système électronique inclut un système d'antenne actif.

13. Système de montage selon la revendication 8 comprenant en outre une pluralité de dissipateurs thermiques, un dissipateur thermique positionné le long de chacune des régions de bord latéral de l'élément de plaque de structure de montage.

14. Système de montage selon la revendication 11 dans lequel la structure dissipatrice de chaleur inclut une pluralité d'ailettes formées d'un seul tenant avec la structure de montage pour dissiper par convection de la chaleur du système électronique.

15. Système de montage selon la revendication 14 dans lequel les ailettes d'un seul tenant formées s'étendent autour d'une périphérie de la structure de montage et au moins un passage en serpentin est positionné à proximité d'ailettes au niveau des régions de bord latéral de l'élément de plaque.
